# EUROPEAN PATENT APPLICATION

(11) **EP 4 582 208 A1**
(43) Date of publication of application: **09.07.2025**
(21) Application number: 24219568.3
(22) Date of filing: 12.12.2024
(51) Int. Cl.: B23K 9/095, B23K 9/10, B23K 9/32, H02J 7/00

(54) **MANAGEMENT SYSTEM FOR BATTERY-POWERED WELDING**

(30) Priority: 15.12.2023 US 202363610698 P; 06.12.2024 US 202418972112
(71) Applicant: Illinois Tool Works Inc., Glenview IL 60025 (US)
(72) Inventor: DIECK, Brian Frank, Glenview, 60025 (US); FROLAND, Benjamin Gerald, Glenview, 60025 (US)
(74) Representative: HGF

(57) **Abstract**

The present application describes a management system (100) for battery-powered welding including: communication circuitry (112) configured to communicate with one or more welding-type power supplies (102a-102d) located remotely from the battery-powered welding management system (100); and control circuitry (110) configured to: determine, based on communications with one of the welding-type power supplies (102a-102d), that a charge state of at least one battery powering the one of the welding-type power supplies (102a-102d) has reached a replacement value; determine a location of the one of the welding-type power supplies (102a-102d); and output an alert indicating that the at least one battery should be replaced at the determined location.

## Description

### RELATED APPLICATIONS

The present application claims the benefit of U.S. Patent Application Serial No. 63/610,698, filed December 15, 2023, entitled "MANAGEMENT SYSTEMS FOR BATTERY-POWERED WELDING." The entirety of U.S. Patent Application Serial No. 63/610,698 is expressly incorporated herein by reference.

### FIELD OF THE DISCLOSURE

This disclosure relates generally to welding systems, and more particularly to battery management systems for battery-powered welding.

### BACKGROUND

Conventional welding power supplies are limited to their rated output. In some cases, battery-assisted systems have been used to increase the typical capacity of welding power supplies. However, conventional battery-assisted systems are either integrated with the welding power supply or require the welding power supply to be reconfigured between charging the battery and welding.

### SUMMARY

Battery management systems for battery-powered welding are disclosed, substantially as illustrated by and described in connection with at least one of the figures, as set forth more completely in the claims.

### BRIEF DESCRIPTION OF THE DRAWINGS

FIG. 1 is a block diagram of an example management system for battery-powered welding, in accordance with aspects of this disclosure.
FIG. 2A is a block diagram of an example hybrid welding system in accordance with aspects of this disclosure.
FIG. 2B is a block diagram of another example hybrid welding system in accordance with aspects of this disclosure.
FIG. 3 illustrates an example user interface which may implement the user interface of FIG. 1 to display locations of managed batteries and/or battery-powered welding power supplies.
FIGS. 4A and 4B illustrate a flowchart representative of example machine readable instructions which may be executed by the management system of FIG. 1 to manage battery-powered welding.
FIG. 5 is a block diagram of an example computing device that may implement the management system and/or the external computing system of FIG. 1.

The figures are not necessarily to scale. Wherever appropriate, similar or identical reference numerals are used to refer to similar or identical components.

### DETAILED DESCRIPTION

Conventional battery-powered welders are primarily utilized for small, repair-type jobs, and the work is limited to the amount of welding that can be completed on one charge. For longer-duration welding, users must continue to use AC, cord-connected welders that may involve routing extensive networks of extension cables.

Disclosed example management systems for battery-powered welding power supplies provide a central management of multiple batteries and battery-powered welding power supplies. In some examples, one or more charging stations are connected a management system, which also monitors multiple battery-powered welders. Disclosed example management systems monitor battery usage and charge state (e.g., remaining charge), and will alert the relevant personnel when a battery needs to be replaced at a power supply. The management system may further select the replacement battery and provide replacement location details (e.g., power supply location, operator, power supply information, etc.). Disclosed example management systems allow users to deliver fully charged batteries to replace drained batteries across a jobsite and maintain welding operations at a near continuous duty cycle.

In some examples, the management system operates one or more chargers to charge multiple batteries. A limitless number of charging devices may be connected and managed by the management system to facilitate charging and battery replacement. In some examples, the management system collects information such as battery usage, battery health, battery life, and/or battery inventory, and may display data to a user. For example, the management system may display and/or transmit a graphical user interface to display charge states and/or locations of batteries under management, such as in a map view. Another feature that can offer some level of control and theft deterrence is individual and user level locks and limits applied on the battery welder and/or the charging station. The system will also collect health information of the connected welders and recommend any required service or potential future failure. The charging station will be capable of charging multiple batteries simultaneously or focusing all energy into one battery for an accelerated charge/shorter charging time required.

Disclosed example management systems for battery-powered welding power supplies allow for heavier usage of battery-powered welding at higher utilization rates (e.g., less downtime due to waiting for battery changes) by ensuring that charged batteries are available and present at the locations and times the batteries are needed to continue welding.

Disclosed example management systems for battery-powered welding include: communication circuitry configured to communicate with one or more welding-type power supplies located remotely from the battery-powered welding management system; and control circuitry configured to: determine, based on communications with one of the welding-type power supplies, that a charge state of at least one battery powering the one of the welding-type power supplies has reached a replacement value; determine a location of the one of the welding-type power supplies; and output an alert indicating that the at least one battery should be replaced at the determined location.

In some example management systems, the communication circuitry is configured to communicate wirelessly with the one or more welding-type power supplies. In some example management systems, the communication circuitry is configured to communicate with the one or more welding-type power supplies via at least one of a hub or an access point in communication with the communication circuitry.

In some example management systems, the control circuitry is configured to determine at least one replacement battery to replace the at least one battery powering the one of the welding-type power supplies. In some example management systems, the control circuitry is configured to determine the at least one replacement battery based on a usage history of the one of the welding-type power supplies. In some example management systems, the control circuitry is configured to limit the at least one replacement battery to only be used with the one of the welding-type power supplies. In some example management systems, the control circuitry is configured to limit the at least one replacement battery by programming the at least one replacement battery to operate only with one or more of an identifier of the one of the welding-type power supplies, an operator associated with the one of the welding-type power supplies, or an unlocking code.

Some example management systems further include a battery charger configured to charge a plurality of batteries and having battery locks configured to physically lock the plurality of batteries to the battery charger, in which the control circuitry is configured to control the battery locks to unlock the at least one replacement battery in response to determining the at least one replacement battery. In some example management systems, the control circuitry is configured to schedule replacement of the at least one battery with the at least one replacement battery.

In some example management systems, the communication circuitry is configured to transmit a notification to the one of the welding-type power supplies that a battery replacement has been triggered or scheduled. In some example management systems, the control circuitry is configured to output an interface including locations of the plurality of batteries and charge states of the plurality of batteries.

In some example management systems, the control circuitry is configured to output an interface including locations of the one or more welding-type power supplies and charge states of one or more of the plurality of batteries powering the one or more welding-type power supplies. In some example management systems, the control circuitry is configured to output the alert via the communication circuitry to an external computing device. In some example management systems, the control circuitry is configured to output the alert via a display device coupled to the welding management system.

Some example management systems further include a battery charger configured to charge a plurality of batteries including the at least one battery. In some example management systems, the control circuitry is configured to control the battery charger to selectively direct energy to charge one or more of the plurality of batteries. In some example management systems, the control circuitry is configured to direct the energy to charge the one or more of the plurality of batteries based on a priority assigned to the one or more of the plurality of batteries. In some example management systems, the priority is based on at least one of: a manually assigned priority, a battery type of the one or more of the plurality of batteries, a quantity of the battery type, a battery life configuration, or an environmental condition.

In some example management systems, the control circuitry is configured to determine the replacement value based on a trajectory of the charge state over time. In some example management systems, the control circuitry is configured to, based on an environmental condition present at the one of the welding-type power supplies, at least one of configure a selected replacement battery to perform a procedure or assign an accessory for use with the selected replacement battery.

As used herein, the term "welding-type power" refers to power suitable for welding, plasma cutting, induction heating, CAC-A and/or hot wire welding/preheating (including laser welding and laser cladding). As used herein, the term "welding-type power supply" refers to any device capable of, when power is applied thereto, supplying welding, plasma cutting, induction heating, CAC-A and/or hot wire welding/preheating (including laser welding and laser cladding) power, including but not limited to inverters, converters, resonant power supplies, quasi-resonant power supplies, and the like, as well as control circuitry and other ancillary circuitry associated therewith.

As used herein, a "bidirectional DC-DC converter" refers to any bidirectional circuit topology that converts voltage up and/or down in a first direction and converts voltage up and/or down in a second direction. Example bidirectional DC-DC converters include buck-boost and/or boost-buck topologies, a SEPIC converter, a Cuk converter, or the like. For example, a bidirectional DC-DC converter may refer to a DC-DC converter that boosts voltage in one direction and bucks voltage in the opposing direction.

As used herein, the term "recognized battery unit" refers to a battery unit that is approved, authorized, and/or otherwise has identifiable minimum characteristics, such as charge state, nominal voltage, minimum voltage, maximum voltage, and/or charge capacity. Recognition can occur through signaling, measurement, and/or any other mechanism.

As used herein, a "circuit" includes any analog and/or digital components, power and/or control elements, such as a microprocessor, digital signal processor (DSP), software, and the like, discrete and/or integrated components, or portions and/or combinations thereof.

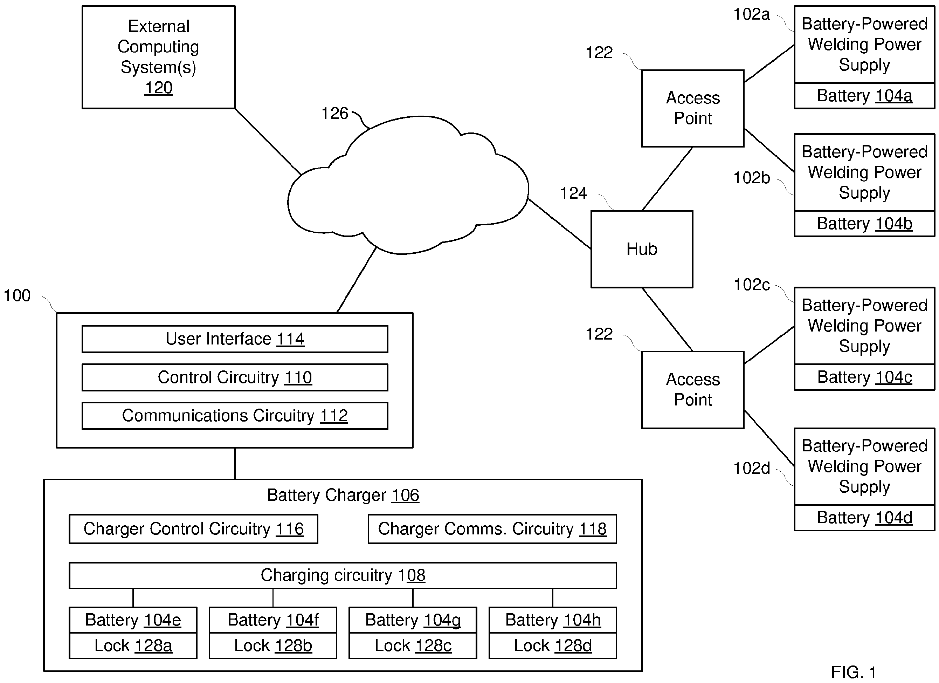

FIG. 1 is a block diagram of an example management system 100 to manage multiple battery-powered welding power supplies 102a-102d. The management system 600 may implement a construction site or other location having multiple battery-powered welding systems which benefit from portability.

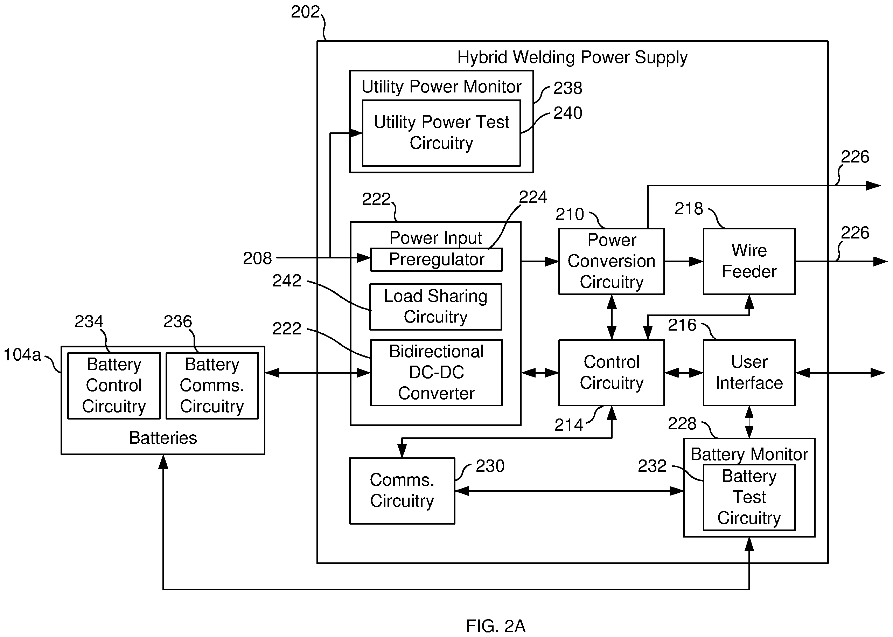

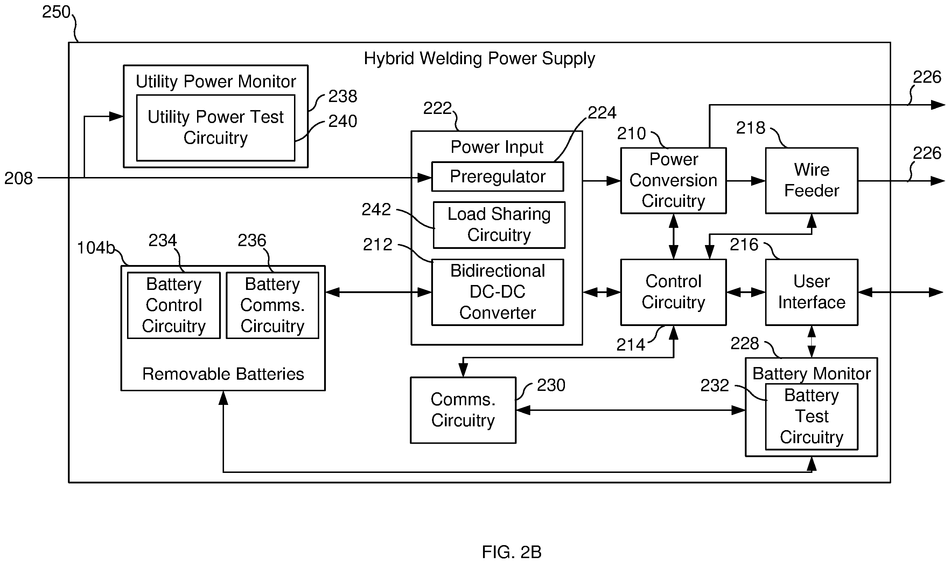

The example battery-powered welding power supplies 102a-102d may be implemented by hybrid welding power supplies 202, 250, examples of which are disclosed below with reference to FIGS. 2A and 2B. Each of the battery-powered welding power supplies 102a-102d include, are connected to, or are otherwise associated with one or more batteries 104a-104d. In the examples disclosed below, the batteries 104a-104d are removable and replaceable. However, in other examples, the batteries 104a-104d are integrated into the battery-powered welding power supplies 102a-102d, and movement and management of the battery involves movement and management of the corresponding battery-powered welding power supplies 102a-102d.

The example management system 100 includes control circuitry 110, communication circuitry 112, and a user interface 114. The management system 100 further includes a battery charger 106 having charging circuitry 108. Additionally or alternatively, the management system 100 may communicate with one or more separate battery chargers 106, which may be remote to the management system 100 and may communicate with the management system 100 via the communication circuitry 112.

The batteries 104e-104h are positioned in the battery charger 106, which may be implemented as a rack, a locker, a cage, or other housing. The batteries 104e-104h may be removed from the battery charger 106 for use and returned to the battery charger 106 for charging or when otherwise not in use.

The charging circuitry 108 provides power to charge the batteries 104e-104h, and/or any other batteries 104a-104d which are connected to the battery charger 106, while the batteries 104e-104h are positioned in the battery charger 106. The charging circuitry 108 may be controlled to charge ones of the batteries 104e-104h according to a determined priority. The charging priority for a given battery 104e-104sh may be based on a quantity of the type of battery that are under management by the system 100, based on battery life cycle preferences, environmental conditions, and/or any other considerations. For example, if the management system 100 has a limited number of the type of the battery 104e, the battery 104e may be assigned a higher charging priority and/or higher charging rate to ensure that a sufficient number of batteries of that type are available to avoid delays due to lack of batteries. In some examples, the management system 100 may assign priorities and/or charging rates based on whether a battery 104e-104h is designated (e.g., by an operator or administrator) to preserve battery life or the battery 104e-104h is configured for fast charging.

The example battery charger 106 further includes charger control circuitry 116 and/or charger communication circuitry 118. The charger communication circuitry 118 may communicate with the batteries 104e-104h, such as by wired communications or wireless communications. For example, the charger communication circuitry 118 may request and receive identifying information and/or battery characteristics from the batteries 104e-104h.

The example battery-powered welding power supplies 102a-102d determine the charge states of the corresponding batteries 104a-104d powering the welding power supplies 102a-102d, and communicate the charge states to the management system 100. For example, the battery-powered welding power supplies 102a-102d may be communicatively coupled, via wired and/or wireless communications, to the management system via one or more access points 122, which may be connected to one or more hubs 124. The access point(s) 122 and hub(s) 124 provide connectivity to the management system 100 via one or more networks 126 (e.g., local area networks, wide area networks, the Internet, etc.). In some other examples, the battery-powered welding power supplies 102a-102d may connect directly to the hub(s) 124, directly to the network(s) 126 (e.g., via cellular communications, satellite communications, etc.), and/or directly with the communication circuitry 112 (e.g., via Bluetooth or other wireless communications) to communicate with the management system 100.

In addition to the charge states, the example battery-powered welding power supplies 102a-102d may communicate location information, operator information, weld history, configured welding programs, assigned welding tasks, and/or any other information that may assist the management system 100 in selecting replacement batteries and/or facilitating delivery of charged batteries for replacement at the battery-powered welding power supplies 102a-102d. The battery-powered welding power supplies 102a-102d may communicate the charge states and/or other information periodically, aperiodically, on demand, in response to a request, in response to an event (e.g., the charge state reaching a specific threshold), and/or at any other time.

The control circuitry 110 and/or the power supplies 102a-102d may determine the locations of the power supplies 102a-102d based on a known location of the access points 122 and/or hubs 124 to which the power supplies 102a-102d are connected. For example, when the power supply 102a is connected to a first access point 122 having a known fixed location, the control circuitry 110 and/or the power supply 102a may use the location of the first access point 122 as the effective location of the power supply 102a. In other examples, the power supplies 102a-102d may be provided with locating equipment, such as GPS circuitry and/or other equipment, to determine and report the locations of the power supplies 102a-102d to the management system 100.

In addition, or as an alternative, to the battery-powered welding power supplies 102a-102d reporting the charge states, the management system 100 may poll the battery-powered welding power supplies 102a-102d at regular and/or irregular intervals, by request of an operator (e.g., in response to an operator request to retrieve updated charge states for one or more of the battery-powered welding power supplies 102a-102d), and/or at any other time.

The example management system 100 may display the statuses of the connected batteries 104e-104h, and assist an operator in selecting one or more of the batteries 104e-104h (e.g., for replacement of the batteries 104a-104d at the battery-powered power supplies 102a-102d via the user interface 114 and/or via an external computing system 120. The user interface 114 may include one or more input devices (e.g., buttons, dials, switches, touchscreen, etc.) and one or more output devices (e.g., displays, touchscreens, etc.). The external computing system 120 may be an operator device (e.g., a smartphone, laptop, tablet computer, etc.) in communication with the management system 100 via the communication circuitry 112 (e.g., via the one or more networks 126). The external computing system 120 may receive information about the power supplies 102a-102d and/or the batteries 104a-104h for remote monitoring and/or battery replacement.

When the management system 100 determines that the charge state of any of the batteries 104a-104d used by the power supplies 102a-102d has reached a replacement value, the management system 100 outputs an alert, notification, and/or other communication indicating that the battery 104a-104d should be replaced. In the example of FIG. 1, the management system 100 further determines the location of the battery 104a-104d (e.g., the location of the power supply 102a-102d powered by the battery 104a-104d), and indicates that the battery 104a-104d is to be replaced at the specified location. For example, the alert or notification may include outputting a message or other notification via the user interface 114, transmitting a notification or message to the external computing system(s) 120, and/or transmitting a notification or message to the power supply 102a-102d.

The replacement value may be a percentage of the battery capacity or maximum battery charge state, or may be a predetermined number of amp-hours remaining in the battery 104a-104h. In some examples, the control circuitry 110 determines the replacement value based on a trajectory (e.g., rate of change, curve fit) of the charge state of the battery 104a, which may allow the control circuitry 110 to predict a time at which the battery 104a is depleted. Based on the estimated time of depletion and the trajectory of depletion, as well as an amount of time needed to schedule and deliver the replacement battery 104e-104h, the control circuitry 110 may determine a replacement value for the charge state, at which time the battery replacement may be scheduled and/or performed. The replacement value may be predictive or reactive (e.g., non-predictive, in response to static criteria).

The control circuitry 110 may further determine a replacement value based on battery health priorities set by a site administrator, equipment manager, and/or other authorized personnel. For example, the replacement value may be a lower charge state to allow for fewer battery replacement tasks, at the potential cost of reduced battery life. Conversely, the replacement value may be a higher charge state to preserve battery life, while requiring more frequency battery replacements.

Additionally or alternatively, the control circuitry 110 may determine the replacement value based on environmental conditions. For example, the control circuitry 110 may determine a different (e.g., higher) replacement value for colder and/or warmer ambient temperatures than for a predetermined normal range of ambient temperatures.

In some examples, the management system 100 identifies one or more batteries 104a-104h to be used as the replacement batter(ies) and/or schedules the replacement of the battery 104a-104d at the specified location. The management system 100 may identify the replacement batter(ies) 104e-104h based on a usage history of the power supply 102a-102d to which the replacement battery 104e-104h will supply power. For example, the management system 100 may select a battery 104e-104h which has a higher capacity and/or higher output amperage rating for a power supply 102a-102d which has a history of higher power outputs. To evaluate the power output of the power supply 102a-102d for purposes of selecting a battery, the management system 100 may compare a number of welds, and/or total amount of time welding, at more than a threshold output power or amperage to a corresponding threshold. Additionally or alternatively, the management system 100 may determine numbers and/or durations of welds using weld schedules configured on the power supply 102a-102d, in which weld schedules may be designated as high-output, medium-output, low-output, and/or any other designation relative to replacement battery selection. Comparisons may be performed for one or more predetermined time periods, such as to determine a frequency of welding above the threshold power output or amperage. Comparisons may be performed based the power supply 102a-102d, based on one or more operators associated with the power supply 102a-102d, and/or based on a combination of power supply and associated operator.

The management system 100 may also use a location of power supply 102a-102d, a set of one or more weld schedules assigned to the power supply 102a-102d, equipped feature(s) and/or equipment associated with the power supply 102a-102d, and/or any other aspect of the power supply 102a-102d to select the replacement batter(ies). For example, the reported or detected location of the power supply 102a-102d may represent areas in which welds of higher power are likely or exclusively performed. In some examples, the communication circuitry 112 transmits a notification to the welding-type power supply 102a-102d that a battery replacement has been triggered or scheduled.

If the management system 100 does not identify the power supply 102a-102d as a higher-output power supply, the management system 100 may select a lower-capacity and/or lower-amperage replacement battery 104e-104h for the power supply 102a-102d. Selecting the replacement battery to have the capacity and/or output appropriate to the power supply 102a-102d enables the management system 100 to conserve higher-cost batteries having higher capacity and/or higher output for higher-power welding applications.

To schedule the replacement, for example, the management system 100 may create a task in a dispatching system to instruct a technician or other personnel to deliver and/or install a replacement battery (e.g., a specified replacement battery 104e-104h selected by the management system 100, a replacement battery 104e-104h selected by the technician or installer, or an arbitrary replacement battery 104e-104h) at a specified location, by or at a specified time. The specified time may be set based on an estimated time at which the designated power supply 102a-102d will require a replacement battery to continue welding. In some examples, the management system 100 associates a person or robot with a scheduled replacement task.

In some examples, the management system 100 configures the selected replacement battery 104e-104h to limit the battery 104e-104h to be used with the designated power supply 102a-102d. To this end, each of the batteries 104e-104h includes control circuitry, which controls charging and discharging of the battery 104e-104h, thermal management, and/or any other monitoring and/or control of the battery 104e-104h. The control circuitry 110 may communicate limits to the control circuitry of the battery 104e-104h via the communication circuitry 112 and the charger communication circuitry 118. The control circuitry 110 may limit the replacement battery 104e-104h by programming the replacement battery 104e-104h to operate only with an identifier of the designated battery-powered welding power supply 102a-102d (e.g., an assigned name, serial number, model number, MAC address, and/or other unique identifier of the power supply 102a-102d), an operator associated with the designed power supply 102a-102d (e.g., operator name, operator identifier, operator credential, or other characteristic of an operator associated with the designated power supply 102a-102d), and/or an unlocking code (e.g., a code provided to the installer or operator to allow operation of the replacement battery 104e-104h). The unlocking code may be entered via an input device on the replacement battery 104e-104h, via an interface on the designed power supply 102a-102d to which the replacement battery 104e-104h is connected, via a computing device communicatively connected to the replacement battery 104e-104h (e.g., a smartphone or tablet wirelessly connected to the replacement battery 104e-104h), and/or via any other input technique.

Based on the environmental conditions, the example control circuitry 110 further configures the selected replacement battery 104e-104h to perform one or more battery preservation routines, such as warming routines that prepare the battery for high-amperage welding applications. Additionally or alternatively, the control circuitry 110 may assign one or more accessories, such as battery warmers or chillers, to be used in conjunction with the selected replacement battery 104e-104h. The assigned accessory may be included in the scheduled replacement task.

In some examples, the battery charger 106 includes a physical lock 128a-128d for one or more battery connections to which the batteries 104e-104h may be connected for charging. The control circuitry 110 may control the locks 128a-128d to physically lock batteries 104e-104h to the battery charger 106 upon insertion, and control the locks 128a-128d to physically unlock ones of the batteries 104e-104h to allow removal in response to selection of the corresponding battery 104e-104h for replacement.

FIG. 2A is a block diagram of an example hybrid welding power supply 202, which may be used to implement any of the battery-powered welding power supplies 102a-102d of FIG. 1.

The hybrid welding power supply 202 is connected to one or more of the batteries 104a-104h of FIG. 1. The batteries 104a-104h may include any type or combination of types of energy storage devices, such as batteries, supercapacitors, thermal energy storage, chemical energy storage, and/or mechanical energy storage devices. While the following examples are discussed with reference to batteries, this disclosure applies to any other type of energy storage that is capable of adaptation for welding.

In some examples, the hybrid welding power supply 202 may also be connected to utility (e.g., AC input) power 208 from a power source such as a generator, a mains power source, a battery-powered inverter supply, and/or any other power source. The hybrid welding power supply 202 may be powered by either or both of the batteries 206 or the utility power 208 at any given time. In other examples, the welding power supply 202 is powered solely by the batteries 104a-104h. While examples are disclosed below with reference to a single one of the batteries 104a, in other examples multiple ones of the batteries 104a-104h may be connected to the welding power supply 202 at a time and/or the batteries 104a-104h may be exchanged.

When the hybrid welding power supply 202 is connected to both the AC input power 208 and the battery 104a, the hybrid welding power supply 202 may charge the battery 104a. Conversely, when energy is required that is not available from the utility power 208, the battery 104a may provide power to the hybrid welding power supply 202.

The hybrid welding power supply 202 includes power conversion circuitry 210, a bidirectional DC-DC converter 212, control circuitry 214, a user interface 216, and a wire feeder 218.

The power conversion circuitry 210 is a circuit that converts direct current (DC) power to welding power. The DC power used by the power conversion circuitry 210 is received from a power input 222. The power input 222 includes a preregulator 224 and/or the bidirectional DC-DC converter 212, and supplies one or more DC buses with energy (e.g., a DC bus for the output of the preregulator 224 and one or more DC buses for the output of the bidirectional DC-DC converter 212, one DC bus for each battery connection, etc.). The preregulator 224 may include a rectifier to rectify the AC input from the utility power 208. The preregulator 224 further includes circuitry to convert the rectified AC input to the bus voltage for providing power to the power conversion circuitry 210.

In some examples, the power input 222 includes load sharing circuitry, multiple converters, and/or multi-stage converters, to supply a DC bus with energy from multiple batteries or other energy storage devices. In some examples, the power input 222 may accept energy from different types of batteries simultaneously in addition to accepting energy from multiple batteries of the same type.

The power conversion circuitry 210 converts the energy present at the DC bus (e.g., from the power input 222) to a weld output 226. For example, the power conversion circuitry 210 may include a switched mode power supply, which is controlled by the control circuitry 214 based on specified weld parameters and feedback.

The bidirectional DC-DC converter 212 is a circuit that converts input power (e.g., from the DC bus powered by the utility power 208) to charge the connected battery 104a. The bidirectional DC-DC converter 212 also converts the stored power in the batteries 206 to converted power to output to the power conversion circuitry 210 (e.g., via one or more DC buses) for output to the power conversion circuitry 210. In some examples, the bidirectional DC-DC converter 212 is replaced with one or more unidirectional DC-DC converters to convert the stored power in the battery 104a for output to the power conversion circuitry 210.

The control circuitry 214 controls the power conversion circuitry 210 to output the weld output 226. The control circuitry 214 controls the bidirectional DC-DC converter 212 to convert power from the power input 222 to charge the battery 104a and/or controls the bidirectional DC-DC converter 212 to convert power from the battery 104a to provide the converted battery power to the power conversion circuitry 210. The control circuitry 214 further controls the bidirectional DC-DC converter 212 to charge the battery 104a when the utility power 208 is available and at least a portion of the utility power 208 is available for charging the battery 104a (e.g., the utility power 208 is not completely consumed by the power conversion circuitry 210 and/or the wire feeder 218). Conversely, the control circuitry 214 controls the bidirectional DC-DC converter 212 to convert power from the battery 104a to provide the converted battery power to the power conversion circuitry 210 when a demand for welding power is higher than can be provided by the utility power 208.

The example wire feeder 218 includes a wire feed motor to provide electrode wire to the welding operation (e.g., when the welding operation involves a wire feeder, such as when gas metal arc welding, flux cored arc welding, etc.). When the welding operation involves a wire feeder, the control circuitry 214 controls powers the wire feeder 218. The wire feeder 218 may be powered by the weld output 226 or by another output from the power conversion circuitry 210. In some other examples, the wire feeder 218 may be a separate device connected to the weld output 226 external to the hybrid welding power supply 202.

The user interface 216 enables input to the hybrid welding power supply 202 and/or output from the hybrid welding power supply 202 to a user. The control circuitry 214 may indicate the state of charge of the battery 104a and/or a mode of operation, such as a battery charging mode, an external power welding mode (e.g., welding mode powered by utility power), a combination welding-charging mode (e.g., welding and charging the battery 104a using utility power 208), a battery powered welding mode, or a hybrid welding mode (e.g., welding boost mode powered by utility power and battery power), of the hybrid welding power supply 202 via the user interface 216.

The user interface 216 further includes inputs to allow an operator to specify welding parameters, such as a workpiece thickness, output voltage, output current, wire feed speed, welding wire diameter, welding wire type, welding process, pulse frequency, or pulse magnitude.

The example control circuitry 214 monitors the properties of connected battery 104a and/or utility power 208 to provide information about the connected battery 104a, the utility power 208, and/or the welding capacity to the operator. For example, as the power available to the power input 222 from the battery 104a increases, the control circuitry 214 may determine that thicker materials can be welded, a longer time, length, and/or number of welds of a given length are available to weld for a given set of parameters, use of the utility power 208 can be decreased, the types of usable weld processes increases, the usable consumable sizes (e.g., electrode diameters) increase, and/or other enhancements and/or augmentations to welding may become available. Conversely, as the power available from the battery 104a decreases, the control circuitry 214 may determine that the thickness of materials that can be welded decreases, less time is available to weld for a given set of parameters, more utility power 208 may be needed, the types of usable weld processes are limited, the usable consumable sizes (e.g., electrode diameters) decrease, and/or the hybrid welding power supply 202 becomes otherwise limited. In some examples, the control circuitry 214 responds to the identification of limitations due to battery output amperage, charge state, and/or capacity by transmitting a charge state, location, and/or any other information, to the management system 100 to facilitate a battery replacement.

The control circuitry 214 receives and uses properties of the battery 104a to determine welding capacity, supported values for welding parameters, and/or alternatives to unsupported values for welding parameters. To determine the properties of the battery 104a, the example hybrid welding power supply 202 includes a battery monitor 228 and/or communication circuitry 230.

The battery monitor 228 may interface with the battery 104a to determine one or more properties of the battery 104a, including the charge state of the battery. For example, the battery monitor 228 may include battery test circuitry 232 which can function as one or more loads to the battery 104a while measuring changes in voltage, current, temperature, and/or other properties. Additionally or alternatively, the battery monitor 228 may supply a small current to one of the battery 104a (e.g., from the utility power 208 or another one of the battery 104a) to determine the response. In still other examples, the battery test circuitry 232 may perform voltage and/or current measurements, and/or measure voltage and/or current over time, to learn or infer the properties of the battery 104a. By analyzing the response of the battery 104a, the battery monitor 228 can determine properties of the battery 104a for use by the control circuitry 214 in determining welding capacity. The charge state is communicated to the management system 100 (e.g., via the communication circuitry 230) at regular and/or irregular intervals.

Some types of batteries include battery control circuitry 234 and/or battery communication circuitry 236. For example, battery control circuitry 234 may control internal load balancing of the batteries 206, and/or battery communication circuitry 236 may allow for communication of battery information to external devices and/or implement control of one or more aspects of the battery 104a by an external device, such as the management system 100. The example battery communication circuitry 236 of the battery 104a and/or the communication circuitry 230 of the hybrid welding power supply 202 may be configured to communicate through any wired or wireless techniques. For example, the battery communication circuitry 236 and/or the communication circuitry 230 may communicate via serial communications through the battery contacts. In other examples, the battery communication circuitry 236 and/or the communication circuitry 230 may communicate wirelessly via radio frequency identification (RFID), near field communications (NFC), Bluetooth^{®}, and/or any other close-proximity communications, or any other desired wireless communications technique.

The example hybrid welding power supply 202 further includes a utility power monitor 238. The utility power monitor 238 monitors the presence and properties of the utility power 208, and provides the properties of the utility power 208 to the control circuitry 214 to determine welding capacity. Example properties of the utility power 208 that may be monitored include AC voltage, number of phases, frequency, average current limit, peak current limit, a source type of the utility power (e.g., mains power, a battery-powered inverter, a fuel-driven generator, etc.), a circuit breaker type of the utility power, and/or a circuit breaker rating of the utility power. The utility power monitor 238 may receive one or more properties via the user interface 216 and/or by testing the utility power 208 via utility power test circuitry 240. The utility power test circuitry 240 may, for example, measure the AC voltage and/or frequency via a voltage monitor, and/or apply an impulse load to the utility power 208 to measure a current response. The properties of the utility power 208 may be provided to the control circuitry 214 for determination of welding capacity (e.g., in combination with the properties of the battery 104a).

The example power input 222 may further include load sharing circuitry 242. The load sharing circuitry 242 controls a balance of power input from the utility power 208 and the one or more battery 104a. For example, the control circuitry 214 may control the load sharing circuitry 242 to cause relatively more power to be drawn from the utility power 208 to preserve battery life and/or avoid unnecessary battery discharge. The control circuitry 214 may also control the load sharing circuitry 242 to cause relatively more power to be drawn from the batteries, such as to reduce high electricity costs and/or save fuel when utility power 208 is powered by an engine-driven (or other portable fuel-driven) source.

In some examples, the user interface 216 may provide a utility power selection input that defines different levels of power to be drawn from the utility power 208 (e.g., with the balance drawn from the battery 104a). Example utility power levels may include a low utility draw level, a medium utility draw level, and a high utility draw level.

The low utility draw level may be selected to reduce the power drawn from the utility power 208, such as when there are other devices on the utility power branch (e.g., the branch is not dedicated to the power supply 202). For example, the low utility draw level may limit utility drawn to only levels necessary to sustain the welding, with the balance drawn from the battery 104a. Alternatively, the low utility draw level may limit current drawn from the utility power 208 to less than a threshold current to reduce or prevent circuit breaker trips, with power drawn from the battery 104a as needed to reduce the current drawn from the utility power 208.

Conversely, the high utility draw level may be selected to limit power drawn from the battery 104a, such as when there is a known dedicated utility branch for the power supply 202 and/or to maximize utility power usage and/or battery charge.

The medium utility draw level may be selected as a balance between the low and high utility draw levels. There may be more than one medium or intermediate utility draw levels, higher utility draw levels, and/or lower utility draw levels.

FIG. 2B is a block diagram of another example hybrid welding power supply 250. The example hybrid welding power supply 250 is similar to the hybrid welding power supply 202 of FIG. 2A, with the exception that instead of being connected to external batteries 104a-104h, the battery 104b connected to the hybrid welding power supply 250 is a removable battery 104b which may be housed within the hybrid welding power supply 250 during use and/or transport. The hybrid welding power supply 250 similarly includes the power conversion circuitry 210, bidirectional DC-DC converter 212, the control circuitry 214, the user interface 216, the wire feeder 218, the power input 222, the battery monitor 228, the communication circuitry 230, and the utility power monitor 238 as described above with reference to FIG. 2.

The removable battery 104b may be simple batteries or may include battery control circuitry 234 to manage the charge state, charging, and/or discharging of the removable batteries 206. In some examples, the control circuitry 214 communicates with the removable battery 104b via the battery communication circuitry 236 to determine whether the removable battery 104b is a recognized battery unit. For example, the hybrid welding power supply 250 may be configured to operate with certain types of battery packs having specific characteristics. In some examples, the management system 100 of FIG. 1 selects replacement batteries for the hybrid welding power supply 250 based on the compatibility of the replacement battery with the hybrid welding power supply 250. The control circuitry 214 may communicate with the battery control circuitry 234 in the removable battery 104b via the battery communication circuitry 236 to identify the type of battery pack and, if a type of battery pack is identified, determine whether the identified type is recognized. A removable battery 104b may be recognized by being authorized, approved, included in a list of battery packs accessible by the control circuitry 214, and/or through any other method of recognition or identification of the removable battery 104b as suitable.

When the control circuitry 214 detects that the removable battery 104b is recognized, the control circuitry 214 may control the bidirectional DC-DC converter 212 to charge the removable battery 104b based on one or more predetermined properties of the removable batteries 206 (e.g., charge state, energy storage capacity, etc.). The control circuitry 214 may also control the bidirectional DC-DC converter 212 to convert power from the removable battery 104b based on the one or more characteristics of the authorized battery unit to provide the converted power to the power conversion circuitry 210. The control circuitry 214 may, in some examples, control the power conversion circuitry 210 to limit the welding power based on the one or more characteristics of the removable battery 104b.

Conversely, if the control circuitry 214 does not identify the removable battery 104b as a recognized battery, the control circuitry 214 may enable welding without use of the removable battery 104b, (e.g., control the bidirectional DC-DC converter 212 so as to disable converting power from the removable battery 104b), disable the bidirectional DC-DC converter 212 (e.g., prevent the bidirectional DC-DC converter 212 from charging or discharging the removable batteries 104b), and/or display a notification via the user interface 216. The notification may be a simple LED, a text-based message, an image displayed via the display device, an audible alert, an and/or any other type of notification.

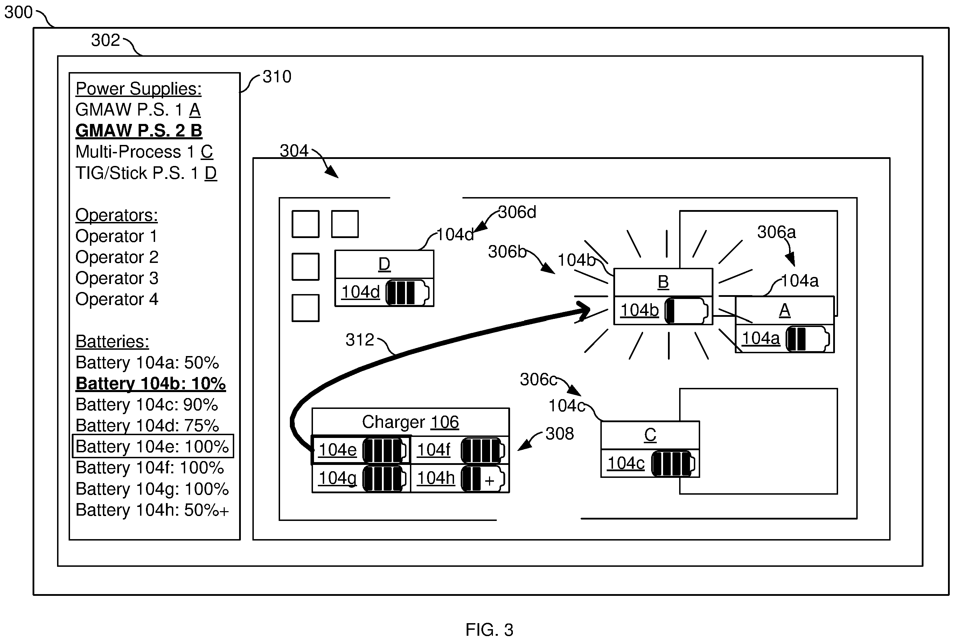

FIG. 3 illustrates an example user interface 300 which may implement the user interface 114 of FIG. 1 and/or an interface on the external computing device 120 to display locations of managed batteries 104a-104h and/or battery-powered welding power supplies 102a-102d.

The user interface 300 further includes a display screen 302 to output or convey information to the operator. The display screen 302 may be any display device capable of displaying visual graphical objects and/or alphanumeric texts relating to the setting of welding parameters, real-time operational statuses of the battery-powered welding power supplies 102a-102d. For example, the display screen 318 may be a liquid crystal display (LCD) screen, an organic LED (OLED) display, and/or any other type of display capable of outputting information to the operator. In the example of FIG. 3, the display screen 302 may be a touchscreen capable of receiving inputs corresponding to locations on the display screen 302.

The example user interface 300 displays a map 304 showing an overhead view of a selected area. Based on the location information received from the power supplies 102a-102d, the user interface 300 displays the locations of the power supplies 102a-102d within the displayed area. Each of the power supplies 102a-102d is represented by a corresponding indicator 306a-306d, which may display additional information such as the charge state of the battery 104a-104d powering the power supply 102a-102d. The user interface 300 further includes an indicator 308 to display the location of the battery charger 106.

The example user interface 300 further displays a listing 310. The listing 310 may display, in list form, one or more of the managed power supplies 102a-102d, operators associated with the managed power supplies 102a-102d, and managed batteries 104a-104h. The listing 310 may highlight or otherwise visually distinguish batteries (e.g., battery 104b in FIG. 3) has a charge state that is less than a determined replacement value and/or power supplies (e.g., GMAW P.S. 2) associated with such batteries.

In the example of FIG. 3, the display screen 302 further illustrates a battery 104b that has a charge state less than a determined replacement value in the map 304. The example management system 100 has determined that the battery 104e, located at the charger 106, is to be used as a replacement battery for the power supply 104b. The display screen 302 illustrates the scheduled replacement using an indicator 312. The replacement indicator 312 and the map view easily indicates to a technician or other personnel the identity of the designated replacement battery 104e and the location to which the battery 104e is to be delivered.

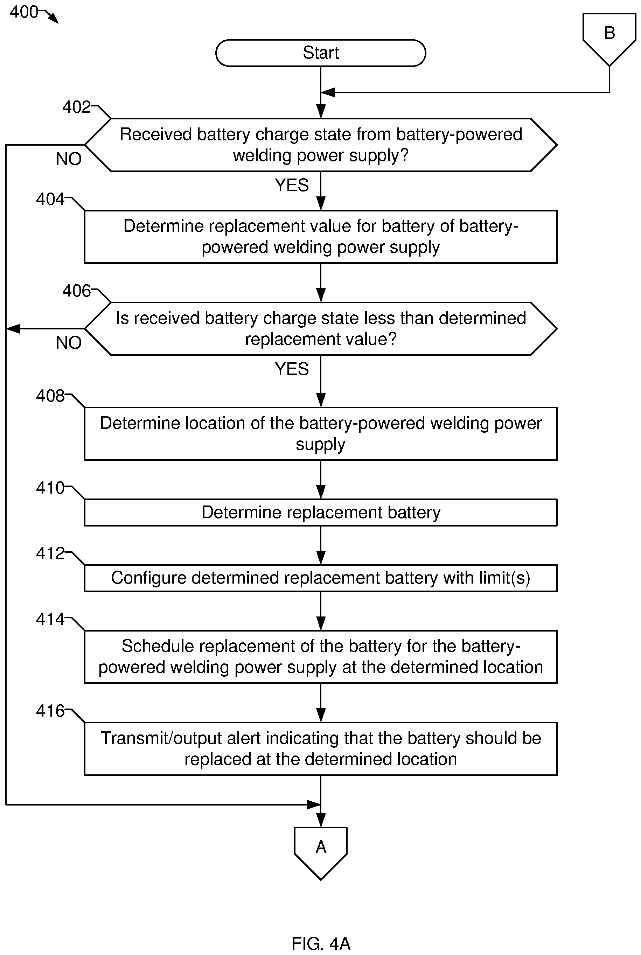

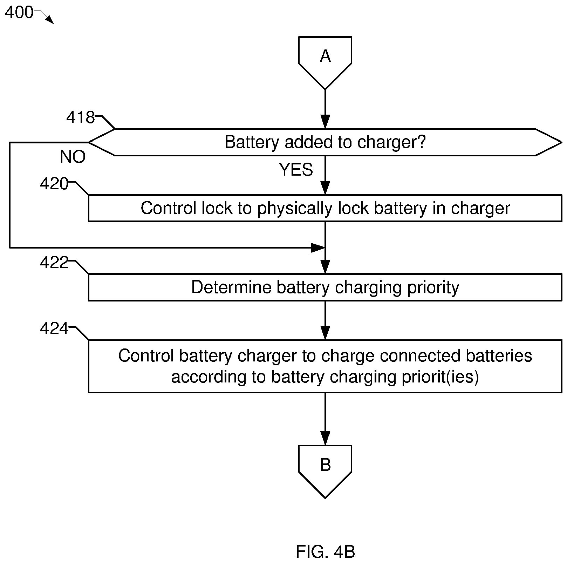

FIGS. 4A and 4B illustrate a flowchart representative of example machine readable instructions 400 which may be executed to implement the management system 100 of FIG. 1 to manage batteries for battery-powered welding power supplies. For example, the control circuitry 110 may execute the instructions 400 to monitor charge states of the batteries 104a-104h, identify batteries for replacement of batteries which have charge states that have reached a replacement value, and/or schedule replacements of the batteries 104a-104h.

At block 402, the control circuitry 110 determines whether a battery charge state has been received from a battery-powered welding power supply. For example, the control circuitry 110 may receive a communication from one of the power supplies 102a-102d via the communication circuitry 112, including the charge state, a location of the power supply 102a-102d, and/or welding information that may influence a selection of the replacement battery.

If a battery charge state has been received (block 402), at block 404 the control circuitry 110 determines a replacement value for the battery (e.g., the battery 104a) of the battery-powered welding power supply (e.g., the power supply 102a). For example, the control circuitry 110 may determine the replacement value based on a trajectory of the charge state of the battery 104a, which may allow the control circuitry 110 to predict a time at which the battery 104a is depleted. Based on the estimated time of depletion and the trajectory of depletion, as well as an amount of time needed to schedule and deliver the replacement battery 104e-104h, the control circuitry 110 may determine a replacement value for the charge state, at which time the battery replacement may be scheduled and/or performed. The replacement value may be predictive or reactive (e.g., non-predictive, in response to static criteria).

The control circuitry 110 may further determine a replacement value based on battery health priorities set by a site administrator, equipment manager, and/or other authorized personnel. For example, the replacement value may be a lower charge state to allow for fewer battery replacement tasks, at the potential cost of reduced battery life. Conversely, the replacement value may be a higher charge state to preserve battery life, while requiring more frequency battery replacements.

At block 406, the control circuitry 110 determines whether the received battery charge state is less than the determined replacement value. If the received battery charge state is less than the replacement value (block 406), at block 408 the control circuitry 110 determines the location of the battery-powered welding power supply 102a-102d. For example, the location may be reported with the charge state, and/or the control circuitry 110 may determine the location of the power supply 102a-102d based on an access point 122 or hub 124 to which the power supply 102a-102d is connected.

At block 410, the control circuitry 110 determines (e.g., selects) a replacement battery 104e-104h for replacement at the power supply 102a-102d. The control circuitry 110 may select the replacement battery 104e-104h based on the welding history of the power supply 102a-102d, characteristics and/or features of the power supply 102a-102d, and/or any other aspects of the power supply 102a-102d and/or the batteries 104e-104h to select the replacement battery.

At block 412, the control circuitry 110 configures the determined replacement battery 104e-104h with limit(s). For example, the control circuitry 110 may limit the replacement battery 104e-104h by programming the replacement battery 104e-104h to operate only with an identifier of the designated battery-powered welding power supply 102a-102d, an operator associated with the designated power supply 102a-102d, an unlocking code, and/or any other limits. In some examples, the control circuitry 110 may omit block 412.

At block 414, the control circuitry 110 schedules the replacement of the battery 104a for the battery-powered welding power supply 102a at the determined location. For example, the management system 100 may create a task in a dispatching system to instruct a technician or other personnel to deliver and/or install a replacement battery, at a specified location, by or at a specified time.

At block 416, the control circuitry 110 transmits or outputs an alert indicating that the battery 104a should be replaced at the determined location. The alert may be output via the user interface 114, via one or more external computing devices 120, at the power supply 102a, and/or at any other desired location.

Turning to FIG. 4B, after transmitting/outputting the alert (block 416), if the battery charge state is not less than the replacement value (block 406), and/or if a battery charge state has not been received (block 402), at block 418 the control circuitry 110 determines whether a battery has been added to the battery charger 106. For example, the control circuitry 110 determines whether a battery 104e-104h has been inserted, plugged, or otherwise connected into a corresponding battery charging connection of the battery charger 106.

If a battery 104e-104h has been added to the charger 106 (block 418), at block 420 the control circuitry 110 controls the corresponding lock 128a-128d to physically lock the added battery 104e-104h in the charger 106. The lock 128a-128d may be controlled to unlock ones of the batteries 104e-104h that are selected for replacement at a power supply 102a-102d.

After locking the added battery (block 420), or if a battery has not been added (block 418), at block 422 the control circuitry 110 determines a battery charging priority. For example, ones of the batteries 104e-104h may be selected for preferential charging, designated for battery life preservation or fast charging, or otherwise designated for a higher or lower charging priority. The battery charging priority may be based on individual battery priorities, priorities for different battery types, and/or system-level priorities.

At block 424, the control circuitry 110 controls the battery charger 106 (e.g., via the charging circuitry 108, the charger control circuitry 116) to charge the connected batteries 104e-104h according to the respective battery charging priorities. Control may then return to block 402.

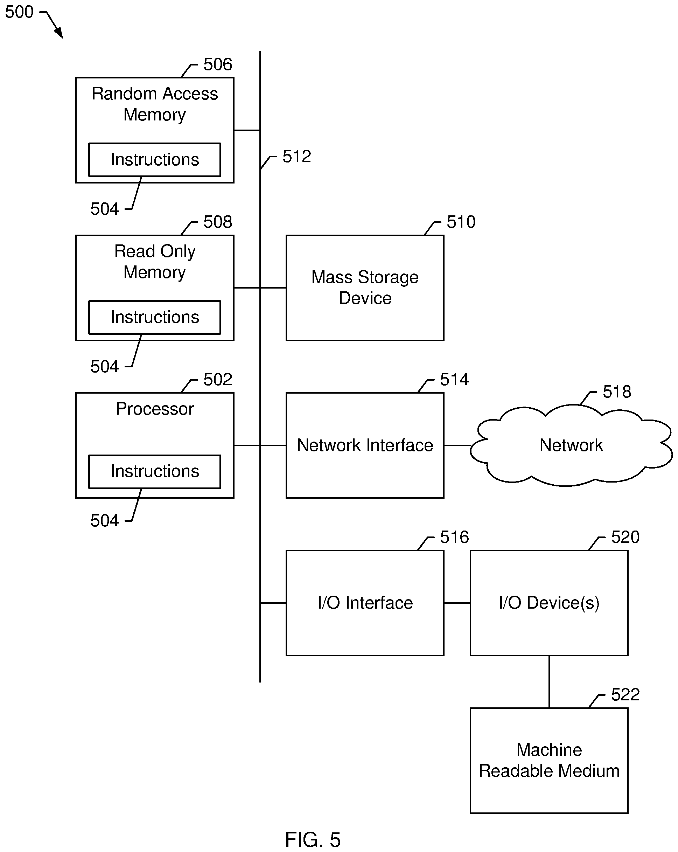

FIG. 5 is a block diagram of an example computing device 500 that may implement the management system 100 and/or the external computing system 120 of FIG. 1. The example computing device 500 of FIG. 5 may be a general-purpose computer, a laptop computer, a tablet computer, a mobile device, a server, and/or any other type of computing device. In some examples, the computing device 500 may be implemented in a cloud computing environment using one or more physical machines and, in some examples, one or more virtual machines in the data center.

The example computing device 500 of FIG. 5 includes a processor 502. The example processor 502 may be any general purpose central processing unit (CPU) from any manufacturer. In some other examples, the processor 502 may include one or more specialized processing units, such as graphic processing units and/or digital signal processors. The processor 502 executes machine readable instructions 504 that may be stored locally at the processor (e.g., in an included cache), in a random access memory 506 (or other volatile memory), in a read only memory 508 (or other non-volatile memory such as FLASH memory), and/or in a mass storage device 510. The example mass storage device 510 may be a hard drive, a solid state storage drive, a hybrid drive, a RAID array, and/or any other mass data storage device.

A bus 512 enables communications between the processor 502, the RAM 506, the ROM 508, the mass storage device 510, a network interface 514, and/or an input/output interface 516.

The example network interface 514 includes hardware, firmware, and/or software to connect the computing device 500 to a communications network 518 such as the Internet. For example, the network interface 514 may include IEEE 802.X-compliant wireless and/or wired communications hardware for transmitting and/or receiving communications.

The example I/O interface 516 of FIG. 5 includes hardware, firmware, and/or software to connect one or more input/output devices 520 to the processor 502 for providing input to the processor 502 and/or providing output from the processor 502. For example, the I/O interface 516 may include a graphics processing unit for interfacing with a display device, a universal serial bus port for interfacing with one or more USB-compliant devices, a FireWire, a field bus, and/or any other type of interface. Example I/O device(s) 520 may include a keyboard, a keypad, a mouse, a trackball, a pointing device, a microphone, an audio speaker, a display device, an optical media drive, a multi-touch touch screen, a gesture recognition interface, a magnetic media drive, and/or any other type of input and/or output device.

The example computing device 500 may access a non-transitory machine readable medium 522 via the I/O interface 516 and/or the I/O device(s) 520. Examples of the machine readable medium 522 of FIG. 5 include optical discs (e.g., compact discs (CDs), digital versatile/video discs (DVDs), Blu-ray discs, etc.), magnetic media (e.g., floppy disks), portable storage media (e.g., portable flash drives, secure digital (SD) cards, etc.), and/or any other type of removable and/or installed machine readable media.

The present methods and systems may be realized in hardware, software, and/or a combination of hardware and software. Example implementations include an application specific integrated circuit and/or a programmable control circuit.

As utilized herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As utilized herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z". As utilized herein, the term "exemplary" means serving as a non-limiting example, instance, or illustration. As utilized herein, the terms "e.g.," and "for example" set off lists of one or more non-limiting examples, instances, or illustrations. As utilized herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.).

While the present method and/or system has been described with reference to certain implementations, it will be understood by those skilled in the art that various changes may be made and equivalents may be substituted without departing from the scope of the present method and/or system. For example, block and/or components of disclosed examples may be combined, divided, re-arranged, and/or otherwise modified. In addition, many modifications may be made to adapt a particular situation or material to the teachings of the present disclosure without departing from its scope. Therefore, the present method and/or system are not limited to the particular implementations disclosed. Instead, the present method and/or system will include all implementations falling within the scope of the appended claims, both literally and under the doctrine of equivalents.
Certain embodiments of the invention are described in the following clauses:
Clause 1. A management system for battery-powered welding, comprising:
   communication circuitry configured to communicate with one or more welding-type power supplies located remotely from the battery-powered welding management system; and
   control circuitry configured to:
      determine, based on communications with one of the welding-type power supplies, that a charge state of at least one battery powering the one of the welding-type power supplies has reached a replacement value;
      determine a location of the one of the welding-type power supplies; and
      output an alert indicating that the at least one battery should be replaced at the determined location.
Clause 2. The management system as defined in clause 1, wherein the communication circuitry is configured to communicate wirelessly with the one or more welding-type power supplies.
Clause 3. The management system as defined in clause 1, wherein the communication circuitry is configured to communicate with the one or more welding-type power supplies via at least one of a hub or an access point in communication with the communication circuitry.
Clause 4. The welding management system as defined in clause 1, wherein the control circuitry is configured to determine at least one replacement battery to replace the at least one battery powering the one of the welding-type power supplies.
Clause 5. The welding management system as defined in clause 4, wherein the control circuitry is configured to determine the at least one replacement battery based on a usage history of the one of the welding-type power supplies.
Clause 6. The welding management system as defined in clause 4, wherein the control circuitry is configured to limit the at least one replacement battery to only be used with the one of the welding-type power supplies.
Clause 7. The welding management system as defined in clause 6, wherein the control circuitry is configured to limit the at least one replacement battery by programming the at least one replacement battery to operate only with one or more of an identifier of the one of the welding-type power supplies, an operator associated with the one of the welding-type power supplies, or an unlocking code.
Clause 8. The welding management system as defined in clause 4, further comprising a battery charger configured to charge a plurality of batteries and comprising battery locks configured to physically lock the plurality of batteries to the battery charger, and the control circuitry is configured to control the battery locks to unlock the at least one replacement battery in response to determining the at least one replacement battery.
Clause 9. The welding management system as defined in clause 4, wherein the control circuitry is configured to schedule replacement of the at least one battery with the at least one replacement battery.
Clause 10. The welding management system as defined in clause 1, wherein the communication circuitry is configured to transmit a notification to the one of the welding-type power supplies that a battery replacement has been triggered or scheduled.
Clause 11. The welding management system as defined in clause 1, wherein the control circuitry is configured to output an interface including locations of the plurality of batteries and charge states of the plurality of batteries.
Clause 12. The welding management system as defined in clause 1, wherein the control circuitry is configured to output an interface including locations of the one or more welding-type power supplies and charge states of one or more of the plurality of batteries powering the one or more welding-type power supplies.
Clause 13. The welding management system as defined in clause 1, wherein the control circuitry is configured to output the alert via the communication circuitry to an external computing device.
Clause 14. The welding management system as defined in clause 1, wherein the control circuitry is configured to output the alert via a display device coupled to the welding management system.
Clause 15. The welding management system as defined in clause 1, further comprising a battery charger configured to charge a plurality of batteries including the at least one battery.
Clause 16. The welding management system as defined in clause 15, wherein the control circuitry is configured to control the battery charger to selectively direct energy to charge one or more of the plurality of batteries.
Clause 17. The welding management system as defined in clause 16, wherein the control circuitry is configured to direct the energy to charge the one or more of the plurality of batteries based on a priority assigned to the one or more of the plurality of batteries.
Clause 18. The welding management system as defined in clause 17, wherein the priority is based on at least one of: a manually assigned priority, a battery type of the one or more of the plurality of batteries, a quantity of the battery type, a battery life configuration, or an environmental condition.
Clause 19. The welding management system as defined in clause 1, wherein the control circuitry is configured to determine the replacement value based on a trajectory of the charge state over time.
Clause 20. The welding management system as defined in clause 1, wherein the control circuitry is configured to, based on an environmental condition present at the one of the welding-type power supplies, at least one of configure a selected replacement battery to perform a procedure or assign an accessory for use with the selected replacement battery.

## Claims

1. A management system for battery-powered welding, comprising:
communication circuitry configured to communicate with one or more welding-type power supplies located remotely from the battery-powered welding management system; and
control circuitry configured to:
determine, based on communications with one of the welding-type power supplies, that a charge state of at least one battery powering the one of the welding-type power supplies has reached a replacement value;
determine a location of the one of the welding-type power supplies; and
output an alert indicating that the at least one battery should be replaced at the determined location.

2. The management system as defined in claim 1, wherein the communication circuitry is configured to communicate wirelessly with the one or more welding-type power supplies.

3. The management system as defined in claim 1, wherein the communication circuitry is configured to communicate with the one or more welding-type power supplies via at least one of a hub or an access point in communication with the communication circuitry.

4. The welding management system as defined in claim 1, wherein the control circuitry is configured to determine at least one replacement battery to replace the at least one battery powering the one of the welding-type power supplies.

5. The welding management system as defined in claim 4, wherein the control circuitry is configured to determine the at least one replacement battery based on a usage history of the one of the welding-type power supplies.

6. The welding management system as defined in claim 4, wherein the control circuitry is configured to limit the at least one replacement battery to only be used with the one of the welding-type power supplies, and optionally
wherein the control circuitry is configured to limit the at least one replacement battery by programming the at least one replacement battery to operate only with one or more of an identifier of the one of the welding-type power supplies, an operator associated with the one of the welding-type power supplies, or an unlocking code.

7. The welding management system as defined in claim 4, further comprising a battery charger configured to charge a plurality of batteries and comprising battery locks configured to physically lock the plurality of batteries to the battery charger, and the control circuitry is configured to control the battery locks to unlock the at least one replacement battery in response to determining the at least one replacement battery.

8. The welding management system as defined in claim 4, wherein the control circuitry is configured to schedule replacement of the at least one battery with the at least one replacement battery.

9. The welding management system as defined in claim 1, wherein the communication circuitry is configured to transmit a notification to the one of the welding-type power supplies that a battery replacement has been triggered or scheduled.

10. The welding management system as defined in claim 1, wherein the control circuitry is configured to output an interface including locations of the plurality of batteries and charge states of the plurality of batteries, or
wherein the control circuitry is configured to output an interface including locations of the one or more welding-type power supplies and charge states of one or more of the plurality of batteries powering the one or more welding-type power supplies.

11. The welding management system as defined in claim 1, wherein the control circuitry is configured to output the alert via the communication circuitry to an external computing device, or
wherein the control circuitry is configured to output the alert via a display device coupled to the welding management system.

12. The welding management system as defined in claim 1, further comprising a battery charger configured to charge a plurality of batteries including the at least one battery.

13. The welding management system as defined in claim 12, wherein the control circuitry is configured to control the battery charger to selectively direct energy to charge one or more of the plurality of batteries.

14. The welding management system as defined in claim 13, wherein the control circuitry is configured to direct the energy to charge the one or more of the plurality of batteries based on a priority assigned to the one or more of the plurality of batteries, and optionally
wherein the priority is based on at least one of: a manually assigned priority, a battery type of the one or more of the plurality of batteries, a quantity of the battery type, a battery life configuration, or an environmental condition.

15. The welding management system as defined in claim 1, wherein the control circuitry is configured to determine the replacement value based on a trajectory of the charge state over time, or
wherein the control circuitry is configured to, based on an environmental condition present at the one of the welding-type power supplies, at least one of configure a selected replacement battery to perform a procedure or assign an accessory for use with the selected replacement battery.
